# EUROPEAN PATENT SPECIFICATION

(11) **EP 3 496 162 B1**
(45) Date of publication and mention of the grant of the patent: **17.03.2021**
(21) Application number: 17836749.6
(22) Date of filing: 20.07.2017
(51) Int. Cl.: H01L 31/0747, H01L 31/18

(54) **SOLAR CELL AND METHOD FOR PRODUCING SOLAR CELL**
SOLARZELLE UND VERFAHREN ZUR HERSTELLUNG EINER SOLARZELLE
CELLULE SOLAIRE ET SON PROCÉDÉ DE FABRICATION

(30) Priority: 04.08.2016 JP 2016153445
(43) Date of publication of application: 12.06.2019
(73) Proprietor: Panasonic Intellectual Property Management Co., Ltd., Osaka-shi, Osaka 540-6207 (JP)
(72) Inventor: MATSUYAMA, Kenta, Osaka-shi, Osaka 540-6207 (JP); FUJITA, Kazunori, Osaka-shi, Osaka 540-6207 (JP); SHIMADA, Satoru, Osaka-shi, Osaka 540-6207 (JP)
(74) Representative: Müller-Boré & Partner Patentanwälte PartG mbB
(86) International application number: PCT/JP2017/026187
(87) International publication number: WO 2018/025643

(56) References cited:
- WO-A1-2016/084299
- JP-A- H09 219 531
- JP-A- 2012 060 080
- JP-A- 2015 185 715
- JP-A- 2017 069 462
- US-A1- 2012 222 731
- US-A1- 2015 047 701
- US-A1- 2016 155 866

## Description

### TECHNICAL FIELD

The present disclosure relates to a solar cell and a method for producing the solar cell.

### BACKGROUND

There has been conventionally known a solar cell in which amorphous silicon layers are formed on both surfaces of a crystalline silicon wafer. For example, Patent Literature 1 discloses a solar cell in which an n-type amorphous silicon layer is formed on a light receiving surface of an n-type crystalline silicon wafer, and a p-type amorphous silicon layer is formed on a rear surface of the wafer. The solar cell disclosed in Patent Literature 1 includes a transparent conductive layer and a collector electrode formed on each of the amorphous silicon layers.

### CITATION LIST

### PATENT LITERATURE

Patent Literature 1: JP 2006-237452 A;
Patent Literature 2: US 2016-0155866 A describes a solar cell that includes a semiconductor substrate, a tunnel layer on the first surface of the semiconductor substrate, a first conductive type semiconductor region on the tunnel layer and includes impurities of a first conductive type, a second conductive type semiconductor region on a second surface and includes impurities of a second conductive type opposite the first conductive type, a first passivation film on the first conductive type semiconductor region, a first electrode formed on the first passivation film and connected to the first conductive type semiconductor region through an opening portion formed in the first passivation film, a second passivation film on the second conductive type semiconductor region, and a second electrode formed on the second passivation film and connected to the second conductive type semiconductor region through an opening portion formed in the second passivation film.

### SUMMARY

### TECHNICAL PROBLEM

Incidentally, it is an important problem to enhance an open circuit voltage (VOC) in a solar cell. Further, in a solar cell, reduction in a breakdown voltage is required.

### SOLUTION TO PROBLEM

A solar cell that is one aspect of the present disclosure includes, in an entire wafer surface and a vicinity of the entire wafer surface, an n-type crystalline silicon wafer having an n⁺ layer having a higher concentration of an n-type dopant than other regions, a silicon oxide layer formed on a light receiving surface of the n-type crystalline silicon wafer, an n-type crystalline silicon layer formed on the silicon oxide layer, and a p-type amorphous silicon layer formed on a rear surface side of the n-type crystalline silicon wafer, wherein the silicon oxide layer contains an n-type dopant, and a concentration of the n-type dopant in the silicon oxide layer is lower than concentrations of n-type dopants in the n⁺ layer and the n-type crystalline silicon layer.

A method for producing a solar cell that is one aspect of the present disclosure includes a first step of submerging an n-type crystalline silicon wafer in an acid aqueous solution containing an n-type dopant, and forming a high concentration n-type dopant-containing silicon oxide layer on an entire surface of the wafer, a second step of forming an i-type silicon layer with substantially intrinsic amorphous silicon or a substantially intrinsic polycrystalline silicon layer as a main component, in a region located on one principal surface of the n-type crystalline silicon wafer, of the high concentration n-type dopant-containing silicon oxide layer, a third step of thermally treating the n-type crystalline silicon wafer, diffusing the n-type dopant to the n-type crystalline silicon wafer and the i-type silicon layer from the high concentration n-type dopant-containing silicon oxide layer, forming, in the entire wafer surface and a vicinity of the entire wafer surface, an n⁺ layer having a higher concentration of the n-type dopant than other regions, and forming an n-type crystalline silicon layer by crystallizing the i-type silicon layer, a fourth step of removing an exposed part that is not covered with the n-type crystalline silicon layer, of a low concentration n-type dopant-containing silicon oxide layer formed by the n-type dopant being partially removed by the third step, and a fifth step of forming a p-type amorphous silicon layer on the other principal surface side of the n-type crystalline silicon wafer.

### ADVANTAGEOUS EFFECTS OF INVENTION

According to one aspect of the present disclosure, a solar cell with a high open circuit voltage (VOC), and a low breakdown voltage can be provided.

### BRIEF DESCRIPTION OF DRAWINGS

FIG. 1 is a sectional view of a solar cell that is an example of an embodiment.
FIG. 2 is a sectional view of a photoelectric conversion part of the solar cell that is an example of the embodiment.
FIG. 3 is a view for explaining a method for producing the solar cell that is an example of the embodiment.
FIG. 4 is a sectional view of a solar cell that is another example of the embodiment.

### DESCRIPTION OF EMBODIMENT

A solar cell of the present disclosure has an n⁺ layer in an entire surface of an n-type crystalline silicon wafer and the vicinity thereof, and includes a silicon oxide layer and an n-type crystalline silicon layer on a light receiving surface of the wafer. On a rear surface of the n-type crystalline silicon wafer, a silicon oxide layer is not formed, but a p-type amorphous silicon layer is formed. By adopting a structure like this, a solar cell having a higher open circuit voltage (VOC), and a lower breakdown voltage compared with the conventional solar cell can be obtained.

Further, the solar cell of the present disclosure includes the crystalline silicon layer on a light receiving surface side of the n-type crystalline silicon wafer as described above, so that an amount of light incident on the wafer is larger, and a higher output characteristic is obtained, compared with the conventional cell including an amorphous silicon layer on the light receiving surface side.

Hereinafter, with reference to the drawings, one example of an embodiment will be described in detail. Note that the solar cell of the present disclosure is not limited to the embodiment described hereinafter. The drawings that are referred to in explanation of the embodiment are schematically illustrated, and dimensions and the like of the components shown in the drawings should be judged with the following explanation taken into consideration.

In the present specification, the description "substantially ∼" is intended to include not only an entire region but also a case substantially recognized as the entire region, explaining with a substantially entire region cited as an example. Further, an n-type dopant means an impurity that functions as a donor, and a p-type dopant means an impurity that functions as an acceptor. Hereinafter, as the silicon oxide layer that is formed on the light receiving surface of the n-type crystalline silicon wafer, a low concentration p-containing silicon oxide layer 13 including low concentration P is illustrated, but the silicon oxide layer may contain an n-type dopant other than P.

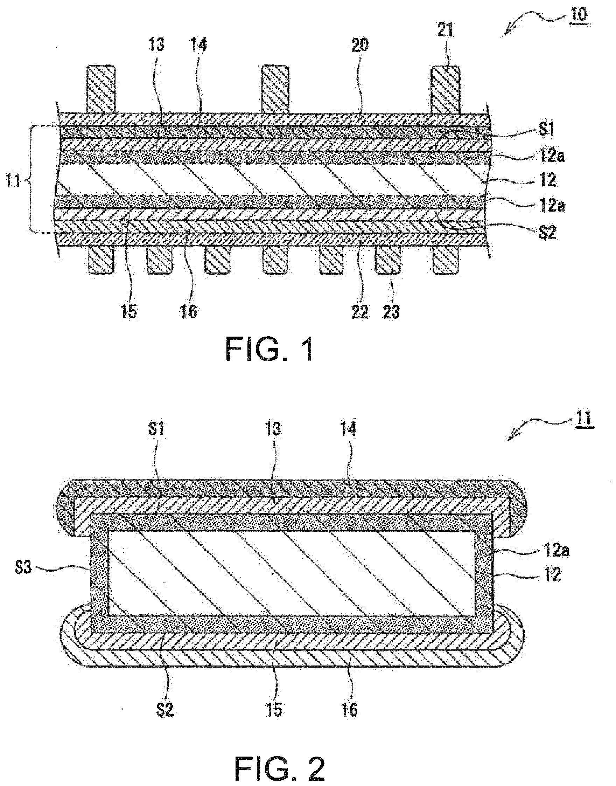

FIG. 1 is a sectional view of a solar cell 10 that is an example of the embodiment. FIG. 2 is a sectional view of a photoelectric conversion part 11 that is one example of the embodiment. As illustrated in FIG. 1 and FIG. 2, the solar cell 10 includes, in a wafer surface and the vicinity thereof, an n-type crystalline silicon wafer 12 having an n⁺ layer 12a having a higher n-type dopant concentration than other regions. Further, the solar cell 10 includes the low concentration P-containing silicon oxide layer 13 formed on a light receiving surface S1 of the n-type crystalline silicon wafer 12, an n-type crystalline silicon layer 14 formed on the low concentration P-containing silicon oxide layer 13, and a p-type amorphous silicon layer 16 formed on a rear surface S2 side of the n-type crystalline silicon wafer 12. The solar cell 10 preferably further includes a passivation layer 15 formed between the n-type crystalline silicon wafer 12 and the p-type amorphous silicon layer 16.

Here, "light receiving surface S1" of the n-type crystalline silicon wafer 12 means a first principal surface on which light is mainly incident (more than 50% to 100%), and "rear surface S2" means a second principal surface on an opposite side to the light receiving surface. Further, "side surface S3" of the n-type crystalline silicon wafer 12 is a surface along a thickness direction of the wafer.

The solar cell 10 is configured by a photoelectric conversion part 11 including the n-type crystalline silicon wafer 12 and the above described respective layers formed on the wafer, and electrodes formed on the photoelectric conversion part 11. In the present embodiment, a transparent conductive layer 20 (first transparent conductive layer) is formed on the n-type crystalline silicon layer 14 of the photoelectric conversion part 11, and a collector electrode 21 (first collector electrode) is formed on the transparent conductive layer 20. Further, a transparent conductive layer 22 (second transparent conductive layer) is formed on the p-type amorphous silicon layer 16, and a collector electrode 23 (second collector electrode) is formed on the transparent conductive layer 22. The transparent conductive layer 20 and the collector electrode 21 constitute a light receiving surface electrode that collects electrons generated in the n-type crystalline silicon wafer 12, and the transparent conductive layer 22 and the collector electrode 23 constitute a rear surface electrode that collects positive holes generated in the n-type crystalline silicon wafer 12.

The n-type crystalline silicon wafer 12 may be an n-type polycrystalline silicon wafer, but is preferably an n-type monocrystalline silicon wafer. The n-type crystalline silicon wafer 12 has, for example, a substantially square shape and has a thickness of 50 to 300 µm. The substantially square shape includes an octagon including two pairs of long sides parallel with one another, with short sides and long sides alternately. For the n-type crystalline silicon wafer 12, a wafer produced by the Czochralski method is used in general, but a wafer produced by an epitaxial growth method may be used.

The n-type crystalline silicon wafer 12 has an n-type dopant. As the n-type dopant, phosphorous (P), arsenic (As), antimony (Sb) and the like are illustrated, and phosphorous (P) is preferably used. A concentration of the n-type dopant in the entire surface of the n-type crystalline silicon wafer 12 and a vicinity thereof is higher than concentrations of the n-type dopants in other regions. That is, in the n-type crystalline silicon wafer 12, an n⁺ layer 12a that is a high dope region with a high concentration of the n-type dopant is present in the entire wafer surface and the vicinity thereof, and a low dope region with a lower concentration of the n-type dopant than the n⁺ layer 12a is present in a region away from the vicinity of the wafer surface. Here, the wafer surface means all surfaces including the light receiving surface S1, the rear surface S2 and the side surfaces S3.

The n⁺ layer 12a is formed with a thickness of 1 µm or less from the surface of the wafer, for example. The n⁺ layer 12a has a concentration gradient such that the concentration of the n-type dopant decreases as a distance from the wafer surface increases. The concentration of the n-type dopant in the n⁺ layer 12a is, for example, 1×10²⁰ atoms/cm³ or less, and an example of a preferable concentration range is 1×10¹⁷ to 1×10²⁰ atoms/cm³. A concentration of the n-type dopant in regions other than the n⁺ layer 12a, that is, the low dope region away from the vicinity of the surface of the wafer is, for example, 1×10¹⁴ to 1×10¹⁶ atoms/cm³. The concentration of the dopant can be measured by a secondary ion mass spectrometry (SIMS).

The n-type crystalline silicon wafer 12 does not substantially contain a p-type dopant such as boron (B). A concentration of the p-type dopant in the n-type crystalline silicon wafer 12 is, for example, less than 1×10¹⁴ atoms/cm³, and is a detection limit by the secondary ion mass spectrometry (SIMS) or less. The p-type amorphous silicon layer 16 is deposited in a low-temperature process, and diffusion of boron (B) into the n-type crystalline silicon wafer 12 from the p-type amorphous silicon layer 16 does not substantially occur. Therefore, in the solar cell 10, a compound defect due to diffusion of boron (B) is not formed, and lifetime reduction of carriers due to the compound defect does not occur.

A texture structure (not illustrated) is preferably formed on the surface of the n-type crystalline silicon wafer 12. The texture structure is a surface uneven structure for restraining surface reflection and increasing a light absorption amount of the n-type crystalline silicon wafer 12. The texture structure can be formed by anisotropically etching a (100) plane of a monocrystalline silicon wafer by using an alkaline solution, and an uneven structure in a pyramid shape with a (111) plane as an inclined plane is formed on the surface of the monocrystalline silicon wafer. A height of the unevenness of the texture structure is 1 to 15 µm, for example.

The low concentration P-containing silicon oxide layer 13 is interposed between the light receiving surface S1 of the n-type crystalline silicon wafer 12 and the n-type crystalline silicon layer 14, and restrains recombination of carriers on the light receiving surface S1 side of the cell. The low concentration P-containing silicon oxide layer 13 is a layer having excellent thermal stability from which a passivation property is not lost even when the layer is exposed to a high temperature, and functions as a so-called tunnel oxide film. The low concentration P-containing silicon oxide layer 13 is formed on the entire light receiving surface S1, for example. The low concentration P-containing silicon oxide layer 13 illustrated in FIG. 2 spreads onto the side surfaces S3 across ends of the light receiving surface S1, and is formed on the entire light receiving surface S1 and part of the side surfaces S3.

The low concentration P-containing silicon oxide layer 13 is made with a silicon oxide as a main component. A thickness of the low concentration P-containing silicon oxide layer 13 is several angstroms to about 50 angstroms, for example, as a specific example, 1 to 20 angstroms. The thickness of the low concentration P-containing silicon oxide layer 13 is measured by a cross-section observation using a transmission electron microscope (TEM) (the same applies to the other layers). The low concentration P-containing silicon oxide layer 13 is a silicon oxide layer including P at a dilute concentration. The concentration of P in the low concentration P-containing silicon oxide layer 13 is lower than a P concentration in the n⁺ layer 12a and a P concentration in the n-type crystalline silicon layer 14.

The n-type crystalline silicon layer 14 is formed on the light receiving surface S1 of the n-type crystalline silicon wafer 12 via the low concentration P-containing silicon oxide layer 13. The n-type crystalline silicon layer 14 is formed on a whole area on the low concentration P-containing silicon oxide layer 13, for example. The n-type crystalline silicon layer 14 illustrated in FIG. 2 spreads onto the side surfaces S3 across the ends of the light receiving surface S1, and is formed on the entire light receiving surface S1 and part of the side surfaces S3. Though details will be described later, the low concentration P-containing silicon oxide layer 13 is etched with the n-type crystalline silicon layer 14 as a mask, so that the low concentration P-containing silicon oxide layer 13 and the n-type crystalline silicon layer 14 are formed on the n-type crystalline silicon wafer 12 in a substantially same pattern.

The n-type crystalline silicon layer 14 is made of a polycrystalline silicon or a microcrystalline silicon doped to an n-type. The n-type crystalline silicon layer 14 contains an n-type dopant, and a concentration of the n-type dopant in the layer is 1×10²¹ atoms/cm³ or less. An example of a preferable concentration range is 1×10¹⁸ to 1×10²¹ atoms/cm³. A thickness of the n-type crystalline silicon layer 14 is 5 to 50 nm, for example. A resistivity of the n-type crystalline silicon layer 14 is higher than that of the transparent conductive layer 20, and is 0.1 to 150 mΩ·cm, for example.

As for n-type dopant concentrations of the respective layer per unit volume in the present embodiment, the P concentration in the low concentration P-containing silicon oxide layer 13 is the lowest, followed by the n⁺ layer 12a, and the P concentration in the n-type crystalline silicon layer 14 is the highest. Further, the P concentration in the low concentration P-containing silicon oxide layer 13 is higher than the concentration in the low dope region of the n-type crystalline silicon wafer 12.

A crystallization rate of the n-type crystalline silicon layer 14 is lower than a crystallization rate of the n-type crystalline silicon wafer 12. Note that the crystallization rate of the n-type crystalline silicon layer 14 is higher than a crystallization rate of the p-type amorphous silicon layer 16. The crystallization rates of the n-type crystalline silicon wafer 12, the n-type crystalline silicon layer 14 and the p-type amorphous silicon layer 16 are measured by cross-section observation of the wafer and the respective layers using a transmission electron microscope (TEM). The crystallization rate is obtained as a ratio of an area of a silicon crystal lattice to an area of an observation region.

An absorption coefficient in a wavelength range of 400 to 600 nm of the n-type crystalline silicon layer 14 is lower than the absorption coefficient of the p-type amorphous silicon layer 16, and is 5×10⁴ to 4×10⁵ cm⁻¹ at a wavelength of 420 nm, for example. A refractive index of the n-type crystalline silicon layer 14 is 2.5 times as high as a refractive index of the transparent conductive layer 20 or more, or 2.5 to 3.2 times as high as the refractive index of the transparent conductive layer 20, for example, in a wavelength range of 355 to 405 nm. When the refractive index of the n-type crystalline silicon layer 14 is in this range, color irregularity of the cell is reduced, and favorable appearance can be easily obtained. Absorption coefficients and refractive indexes of the respective layers are obtained by a spectroscopic ellipsometry device.

The n-type crystalline silicon layer 14 has a lower hydrogen concentration than the p-type amorphous silicon layer 16. Further, the n-type crystalline silicon layer 14 has a lower hydrogen concentration than the passivation layer 15. The hydrogen concentration in the n-type crystalline silicon layer 14 is, for example, 1×10¹⁸ to 1×10²¹ atoms/cm³.

The passivation layer 15 is interposed between the rear surface S2 of the n-type crystalline silicon wafer 12 and the p-type amorphous silicon layer 16, and restrains recombination of carriers on the rear surface S2 side of the cell. The passivation layer 15 is formed on the entire rear surface S2, for example. The passivation layer 15 illustrated in FIG. 2 spreads onto the side surfaces S3 across ends of the rear surface S2, and is formed on the entire rear surface S2 and part of the side surfaces S3. The passivation layer 15 is a layer capable of being deposited at a temperature of approximately 200°C, for example, and has lower thermal stability compared with the low concentration P-containing silicon oxide layer 13.

The passivation layer 15 is made with a substantially intrinsic amorphous silicon (i-type amorphous silicon) or amorphous silicon with a lower concentration of a p-type dopant than the p-type amorphous silicon layer 16 as a main component. The passivation layer 15 may be an i-type amorphous silicon layer that is substantially made of only an i-type amorphous silicon. A thickness of the passivation layer 15 is thicker than the thickness of the low concentration P-containing silicon oxide layer 13, for example, and an example of a preferable thickness range is 5 to 10 nm.

The p-type amorphous silicon layer 16 is formed on the rear surface S2 of the n-type crystalline silicon wafer 12 via the passivation layer 15. The p-type amorphous silicon layer 16 is formed in a whole area on the passivation layer 15, for example. The p-type amorphous silicon layer 16 illustrated in FIG. 2 spreads onto the side surfaces S3 across the ends of the rear surface S2, and is formed on the entire rear surface S2 and part of the side surfaces S3. A thickness of the p-type amorphous silicon layer 16 is, for example, 5 to 25 nm.

The p-type amorphous silicon layer 16 is made of an amorphous silicon doped to a p-type. A concentration of the p-type dopant in the p-type amorphous silicon layer 16 is, for example, 1×10²⁰ atoms/cm³ or more. As the p-type dopant, boron (B), gallium (Ga) and the like can be illustrated. The p-type amorphous silicon layer 16 contains, for example, boron (B) substantially uniformly. Note that a hydrogen concentration of the p-type amorphous silicon layer 16 is higher than the hydrogen concentration of the n-type crystalline silicon layer 14.

The transparent conductive layer 20 is formed on the light receiving surface S1 of the n-type crystalline silicon wafer 12 via the low concentration P-containing silicon oxide layer 13 and the n-type crystalline silicon layer 14. Further, the transparent conductive layer 22 is formed on the rear surface S2 of the n-type crystalline silicon wafer 12 via the passivation layer 15 and the p-type amorphous silicon layer 16. The transparent conductive layers 20 and 22 may be respectively formed on whole of the respective principal surfaces, or may be respectively formed in ranges except for belt-shaped peripheral regions of a width of 2 mm or less from ends of the respective principal surfaces in the respective principal surfaces. The transparent conductive layers 20 and 22 are made of a transparent conductive oxide (IWO, ITO or the like) obtained by doping a metal oxide such as an indium oxide (In₂O₃) and a zinc oxide (ZnO) with tungsten (W), tin (Sn), antimony (Sb) and the like. Thicknesses of transparent conductive layers 20 and 22 are, for example, 30 to 500 nm.

The collector electrodes 21 and 23 respectively contain, for example, a plurality of finger parts, and two or more bus bar parts. The finger parts are electrodes in a thin line shape that are formed in wide ranges of the transparent conductive layers 20 and 22. The bus bar parts are electrodes in a thin line shape that collect carriers from the finger parts, and are formed substantially orthogonal to the respective finger parts. The collector electrodes 21 and 23 may be formed by coating conductive paste on the transparent conductive layers 20 and 22 respectively in patterns including a large number of finger parts and two or more bus bar parts. The collector electrodes 21 and 23 contain, for example, a binder resin such as an acrylic resin, an epoxy resin and phenolic novolac, and conductive particles of silver, copper, nickel or the like dispersed in the binder resin.

The collector electrode 23 is preferably formed with a larger area than the collector electrode 21, and the number of finger parts of the collector electrode 23 which are formed is larger than the number of finger parts of the collector electrode 21. Accordingly, an area of the transparent conductive layer 22 covered with the collector electrode 23 is larger than an area of the transparent conductive layer 20 covered with the collector electrode 21. With a configuration like this, carrier collection efficiency can be enhanced on the rear surface side that is not the light receiving surface side on which light is mainly incident, and output of the solar cell 10 can be enhanced. However, a structure of the electrodes is not limited to this, and a metal layer may be formed on the substantially whole area on the transparent conductive layer 22 as the collector electrode of the rear surface electrode.

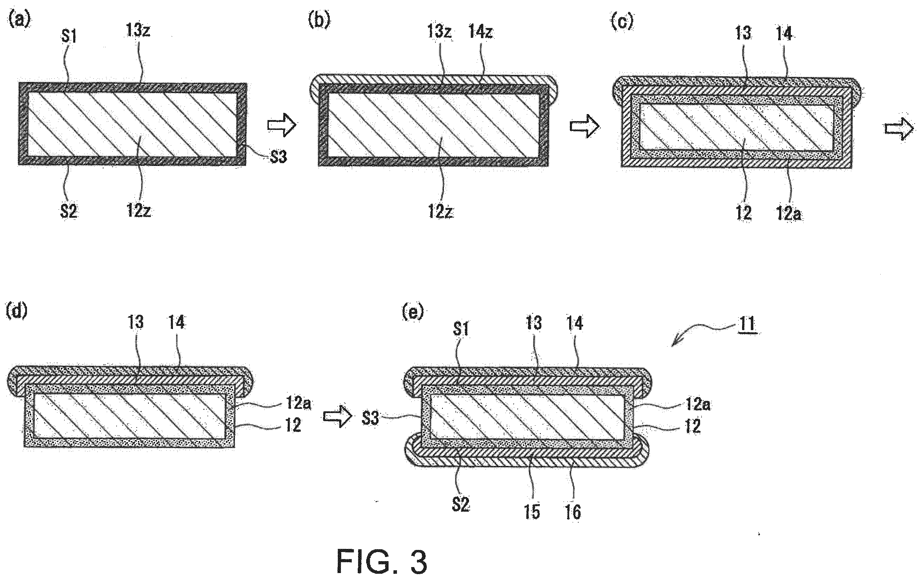

FIG. 3 is a view for explaining an example of a method for producing the solar cell 10. In FIG. 3, an n-type crystalline silicon wafer under production, that is, a wafer that does not have the n⁺ layer 12a, is set as an n-type crystalline silicon wafer 12z. Further, one principal surface of the n-type crystalline silicon wafer 12z is set as the light receiving surface S1, and the other principal surface is set as the rear surface S2.

As illustrated in FIG. 3, a production process of the solar cell 10 includes the following steps.
(1) A First step of submerging the n-type crystalline silicon wafer 12z in an acid aqueous solution containing an n-type dopant, and forming a high concentration n-type dopant-containing silicon oxide layer on the entire wafer surface.
(2) A second step of forming an i-type silicon layer 14z having a substantially intrinsic amorphous silicon, or a substantially intrinsic polycrystalline silicon layer as a main component, in a region located on one principal surface (light receiving surface S1) of the n-type crystalline silicon wafer 12z of the high concentration n-type dopant-containing silicon oxide layer.
(3) A third step of thermally treating the n-type crystalline silicon wafer 12z, and diffusing an n-type dopant to the n-type crystalline silicon wafer 12z and the i-type silicon layer 14z from the high concentration n-type dopant-containing silicon oxide layer.
(4) A fourth step of removing an exposed part, that is not covered with the n-type crystalline silicon layer 14, of a low concentration n-type dopant-containing silicon oxide layer formed by the n-type dopant that was partially removed in the step (3).
(5) A fifth step of forming the p-type amorphous silicon layer 16 on the other principal surface (rear surface S2) side of the n-type crystalline silicon wafer 12.

In the aforementioned step (3), in the entire wafer surface and the vicinity thereof, the n⁺ layer 12a having a higher concentration of the n-type dopant than other regions is formed, the i-type silicon layer 14z is crystallized and the n-type crystalline silicon layer 14 is formed. Further, in the step (3), the n-type dopant is partially removed from the high concentration n-type dopant-containing silicon oxide layer, and the low concentration n-type dopant-containing silicon oxide layer containing a low concentration n-type dopant is formed. Thermal treatment in the step (3) is thermal diffusion treatment of the n-type dopant. The above described production process of the solar cell 10 uses an oxide film formed in a wet process as a diffusion source of the n-type dopant. The low concentration n-type dopant-containing silicon oxide layer substantially functions as a tunnel oxide film.

Hereinafter, phosphorous (P) is assumed to be applied to the n-type dopant contained in the high concentration n-type dopant-containing silicon oxide layer, and the high concentration n-type dopant-containing silicon oxide layer is described as a high concentration P-containing silicon oxide layer 13z. In the wet process in the above described step (1), for example, aqueous phosphoric acid solution is used as the acid aqueous solution (oxidizing chemical solution for silicon) containing the n-type dopant. An example of a preferable acid aqueous solution is a mixed solution of phosphoric acid and nitric acid. For example, a mixed solution is used, which is obtained by mixing an aqueous nitric acid solution of 85 mass% concentration and an aqueous phosphoric acid solution of 70 mass% concentration at a volume ratio of the aqueous nitric acid solution of : the aqueous phosphoric acid solution = 10 : 90 to 50 : 50, preferably 20 : 80 to 40 : 60. Besides the above, an aqueous solution obtained by mixing phosphoric acid as a supply source of the n-type dopant (P) into an aqueous solution having an ability to oxidize the surface of the crystalline silicon wafer 12 may be used. As one example, a mixed solution may be used, which is obtained by further adding phosphoric acid into a mixed solution of a hydrogen peroxide solution (H₂O₂) and hydrochloric acid (HCl).

In the production process of the solar cell 1 0, the n-type crystalline silicon wafer 12z with a texture structure formed on a surface is prepared first. Subsequently, as illustrated in FIG. 3 (a), the high concentration P-containing silicon oxide layer 13z which is a silicon oxide film containing P on the entire wafer surface is formed. A concentration of P contained in the high concentration P-containing silicon oxide layer 13z is, for example, 2×10¹⁹ atoms/cm³ or more. For the n-type crystalline silicon wafer 12z, an n-type monocrystalline silicon wafer doped with P is preferably used. A concentration of P in the n-type crystalline silicon wafer 12z is, for example, 1×10¹⁴ to 1×10¹⁶ atoms/cm³.

As described above, the high concentration P-containing silicon oxide layer 13z is formed by the wet process of submerging the n-type crystalline silicon wafer 12z in the mixed solution of phosphoric acid and nitric acid. By submerging the n-type crystalline silicon wafer 12z in the mixed solution, the high concentration P-containing silicon oxide layer 13z is formed with a thickness of, for example, several angstroms to about 20 angstroms on the entire surface of the wafer including the light receiving surface S1, the rear surface S2 and the side surfaces S3.

One example of a preferable treatment temperature in the present process is 10°C to 90°C. That is, in the present process, the mixed solution adjusted to a temperature of 10°C to 90°C is used. A submerging time period is, for example, one minute to 20 minutes. The thickness and the properties of the high concentration P-containing silicon oxide layer 13z can be adjusted by a mixing ratio of a plurality of acid solutions contained in the oxidizing chemical solution for silicon, concentrations of the respective acid solutions, the treatment temperature, the submerging time period and the like.

Next, as illustrated in FIG. 3 (b), the i-type silicon layer 14z is formed in the region located on the light receiving surface S1 of the n-type crystalline silicon wafer 12z of the high concentration P-containing silicon oxide layer 13z. The i-type silicon layer 14z is formed on the entire light receiving surface S1 and part of the side surfaces S3 on the high concentration P-containing silicon oxide layer 13z. The i-type silicon layer 14z may be made with substantially intrinsic amorphous silicon as the main component, or may be made with a substantially intrinsic polycrystalline silicon layer as the main component.

The i-type silicon layer 14z is deposited by CVD or sputtering, for example. In deposition of the n-type amorphous silicon layer by CVD, source gas obtained by diluting silane gas (SiH₄) by hydrogen can be used. A deposition temperature is, for example, 200 to 300°C. When the deposition temperature is 300°C or less, an amorphous silicon layer is formed, and diffusion of P from the high concentration P-containing silicon oxide layer 13z does not substantially occur.

Next, the n-type crystalline silicon wafer 12z on which the i-type silicon layer 14z is formed is thermally treated. As illustrated in FIG. 3 (c), as a result of the thermal treatment of the present step, P diffuses into the n-type crystalline silicon wafer 12z and the i-type silicon layer 14z from the high concentration P-containing silicon oxide layer 13z. Subsequently, in the entire wafer surface including the light receiving surface S1, the rear surface S2 and the side surfaces S3 and a vicinity thereof, the n⁺ layer 12a having a higher concentration of the n-type dopant than other regions is formed. That is, the n-type crystalline silicon wafer 12 having the n⁺ layer 12a is obtained. Further, the i-type silicon layer 14z is crystallized and the n-type crystalline silicon layer 14 is formed, P is partially removed from the high concentration P-containing silicon oxide layer 13z, and the low concentration P-containing silicon oxide layer 13 containing P of a dilute concentration is formed.

The above described thermal treatment is carried out under a nitrogen atmosphere, for example. One example of a preferable temperature range of the heat treatment is 800°C to 1000°C. The thermal treatment time period is about one minute to 100 minutes, for example. By changing the thermal treatment conditions, a depth in which P diffuses, a concentration of P and the like can be adjusted.

Note that hydrogen (H₂) sintering may be performed to the n-type crystalline silicon wafer 12 after the above described thermal treatment. Hydrogen sintering is performed by thermally treating the n-type crystalline silicon wafer 12 at a temperature of about 350 to 450°C in forming gas obtained by diluting hydrogen gas with inert gas such as nitrogen gas, for example.

Next, as illustrated in FIG. 3 (d), part of the low concentration P-containing silicon oxide layer 13 containing P at a low concentration is removed. In the present step, the n-type crystalline silicon wafer 12 is submerged into hydrogen fluoride and the low concentration P-containing silicon oxide layer 13 is etched. At this time, the n-type crystalline silicon layer 14 is not etched by hydrogen fluoride, but functions as a protection layer. Therefore, a part covered with the n-type crystalline silicon layer 14, of the low concentration P-containing silicon oxide layer 13, is not removed, and a part exposed without being covered with the n-type crystalline silicon layer 14 is removed.

Next, as illustrated in FIG. 3 (e), the passivation layer 15 and the p-type amorphous silicon layer 16 are formed in order on the rear surface S2 of the n-type crystalline silicon wafer 12. In the example illustrated in FIG. 3, the passivation layer 15 is formed on the entire rear surface S2 and part of the side surfaces S3 of the n-type crystalline silicon wafer 12, and the p-type amorphous silicon layer 16 is formed in a same pattern as the passivation layer 15. The passivation layer 15 may be made by using substantially intrinsic amorphous silicon as the main component, and may be made by using amorphous silicon having a lower concentration of the p-type dopant than the p-type amorphous silicon layer 16 as the main component.

The passivation layer 15 and the p-type amorphous silicon layer 16 are deposited by CVD or sputtering, for example. In deposition of the passivation layer 15 (i-type amorphous silicon layer) by CVD, source gas obtained by diluting silane gas (SiH₄) with hydrogen can be used. Further, in deposition of the p-type amorphous silicon layer 16 by CVD, source gas is used, which is obtained by adding diborane (B₂H₆) to silane gas (SiH₄), and diluting the silane gas with diborane added, with hydrogen. By changing a mixing concentration of diborane, the p-type dopant concentration in the p-type amorphous silicon layer 16 can be adjusted.

The solar cell 10 is produced by forming electrodes on the photoelectric conversion part 11 obtained by the aforementioned method. In an electrode forming step of the present embodiment, the transparent conductive layers 20 and 22 are respectively formed on the n-type crystalline silicon layer 14 and on the p-type amorphous silicon layer 16. Next, the collector electrodes 21 and 23 are respectively formed on the transparent conductive layers 20 and 22. The transparent conductive layers 20 and 22 are formed by sputtering, for example. The collector electrodes 21 and 22 are formed by, for example, coating conductive paste containing silver (Ag) particles on the respective transparent conductive layers by screen printing or the like.

According to the aforementioned production method, the solar cell 10 having a high open circuit voltage (VOC), and a low breakdown voltage can be obtained. The solar cell 10 has favorable appearance with no or reduced color unevenness, and has excellent durability.

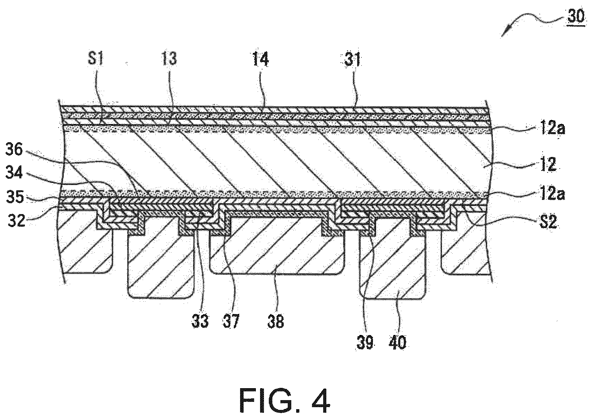

FIG. 4 is a sectional view illustrating a solar cell 30 that is another example of the embodiment. Hereinafter, same reference signs are used for the same components as the components in the aforementioned embodiment, and redundant explanation will be omitted. As illustrated in FIG. 4, the solar cell 30 differs from the solar cell 10 including the electrodes on the light receiving surface S1 side and the rear surface S2 side of the wafer respectively, in the point that the solar cell 30 includes electrodes only on the rear surface S2 side of the n-type crystalline silicon wafer 12.

The solar cell 30 includes the low concentration P-containing silicon oxide layer 13 formed on the light receiving surface S1 of the n-type crystalline silicon wafer 12, and the n-type crystalline silicon layer 14 formed on the low concentration P-containing silicon oxide layer 13, similarly to the case of the solar cell 10. The solar cell 30 further includes a protection layer 31 on the n-type crystalline silicon layer 14. The protection layer 31 protects the n-type crystalline silicon layer 14, for example, and suppresses reflection of solar light in the surface of the cell. The protection layer 31 is preferably made of a material with high optical transparency, and is made with an insulating material such as silicon oxide, silicon nitride, or silicon oxynitride as a main component, for example.

The solar cell 30 includes an n-type amorphous silicon layer 32 formed on a first region on the rear surface S2 of the n-type crystalline silicon wafer 12, and an insulation layer 33 formed in a part on the n-type amorphous silicon layer 32. Further, the solar cell 30 includes a p-type amorphous silicon layer 34 formed on a second region of the rear surface S2 of the n-type crystalline silicon wafer 12 and on the insulation layer 33. Further, the solar cell 30 preferably includes passivation layers 35 and 36 that are respectively formed between the n-type crystalline silicon wafer 12 and the respective amorphous silicon layers. The n-type amorphous silicon layer 32 and the p-type amorphous silicon layer 34 respectively form a p-type region and an n-type region on a rear surface side of the n-type crystalline silicon wafer 31.

An area of the p-type region formed on the rear surface S2 of the n-type crystalline silicon wafer 12 is preferably larger than an area of the n-type region. The p-type regions and the n-type regions are alternately disposed in one direction, for example, and are formed in a comb-shaped pattern in plan view in which the p-type regions and the n-type regions are meshed with each other. In the solar cell 30, a part of the p-type region overlaps a part of the n-type region, and the p-type regions and the n-type regions are formed without a gap on the rear surface S2 of the n-type crystalline silicon wafer 12. In portions where the p-type region and the n-type region overlap each other, the insulation layer 33 is provided between the respective regions. The insulation layer 33 is made, for example, by using silicon oxide, silicon nitride, silicon oxynitride or the like as a main component. The insulation layer 33 may be made of the same material as the protection layer 31.

The n-type amorphous silicon layer 32 is an amorphous silicon layer doped to n-type. A concentration of the n-type dopant in the n-type amorphous silicon layer 32 is, for example, 1×10²⁰ atoms/cm³ or more. The n-type dopant is not specially limited, but P is used in general. The n-type amorphous silicon layer 32 and the p-type amorphous silicon layer 34 have higher hydrogen concentrations than the n-type crystalline silicon layer 14. The passivation layers 35 and 36 are each made with substantially intrinsic i-type amorphous silicon, or amorphous silicon having a lower concentration of the n-type dopant than the n-type amorphous silicon layer 32 as a main component.

The solar cell 30 includes a transparent conductive layer 37 (first transparent conductive layer) and a collector electrode 38 (first collector electrode) that are formed on the n-type amorphous silicon layer 32, and a transparent conductive layer 39 (second transparent conductive layer) and a collector electrode 40 (second collector electrode) that are formed on the p-type amorphous silicon layer 34. The transparent conductive layers 37 and 39 are separated from each other in a position corresponding to the insulation layer 33. The collector electrodes 38 and 40 are formed respectively on the transparent conductive layers 37 and 39. The collector electrodes 37 and 39 are made of a metal such as nickel (Ni), copper (Cu), and silver (Ag), may be of a laminated structure of an Ni layer and a Cu layer, and may have a tin (Sn) layer on the top surface to enhance corrosion resistance.

The solar cell 30 can be produced by the aforementioned production method using an oxide film formed in a wet process as a diffusion source of the n-type dopant, similarly to the solar cell 10. That is, a photoelectric conversion part of the solar cell 30 can be produced through the aforementioned steps (1) to (5).

### REFERENCE SIGNS LIST

10 Solar cell, 11 Photoelectric conversion part, 12, 12z n-type crystalline silicon wafer, 12a n⁺ layer, 13 Low concentration P-containing silicon oxide layer, 13zHigh concentration P-containing silicon oxide layer, 14 n-type crystalline silicon layer, 14z i-type silicon layer, 15 Passivation layer, 16 p-type amorphous silicon layer, 20, 22 Transparent conductive layer, 21, 23 Collector electrode, S1 Light receiving surface, S2 Rear surface, S3 Side surface

## Claims

1. A solar cell (10) comprising:
an n-type crystalline silicon wafer (12, 12z) ;
in the entire wafer surface (S1, S2, S3) and in the vicinity of the entire wafer surface (S1, S2, S3) an n layer (12a) having a higher concentration of an n-type dopant than other regions of the n-type crystalline silicon wafer (12, 12z);
a silicon oxide layer formed on a light receiving surface (S1) of the n-type crystalline silicon wafer (12, 12z);
an n-type crystalline silicon layer (14) formed on the silicon oxide layer; and
a p-type amorphous silicon layer (16) formed on a rear surface side of the n-type crystalline silicon wafer (12, 12z),
wherein the silicon oxide layer contains an n-type dopant, and
a concentration of the n-type dopant in the silicon oxide layer is lower than a concentration of n-type dopants in the n⁺ layer (12a) and in the n-type crystalline silicon layer (14).

2. The solar cell (10) according to claim 1 further comprising a passivation layer (15) formed between the n-type crystalline silicon wafer (12, 12z) and the p-type amorphous silicon layer (16),
wherein the passivation layer (15) is made with substantially intrinsic amorphous silicon, or an amorphous silicon having a lower concentration of a p-type dopant than the p-type amorphous silicon layer (16), as a main component.

3. The solar cell (10) according to claim 1 or 2,
wherein a concentration of the n-type dopant in the n-type crystalline silicon layer (14) is 1×10²¹ atoms/cm³ or less.

4. The solar cell (10) according to any one of claims 1 to 3,
wherein a concentration of the n-type dopant in the n⁺ layer (12a) is 1×10²⁰ atoms/cm³ or less.

5. The solar cell (10) according to any one of claims 1 to 4 comprising:
a first transparent conductive layer (20) formed on the n-type crystalline silicon layer (14);
a first collector electrode (21) formed on the first transparent conductive layer;
a second transparent conductive layer (22) formed on the p-type amorphous silicon layer (16); and
a second collector electrode (23) formed on the second transparent conductive layer.

6. The solar cell (30) according to any one of claims 1 to 4 comprising:
an n-type amorphous silicon layer (32) formed on a first region on a rear surface (S2) of the n-type crystalline silicon wafer (31);
an insulation layer (33) formed in a part on the n-type amorphous silicon layer;
the p-type amorphous silicon layer (34) formed on a second region of the rear surface (S2) of the n-type crystalline silicon wafer (31), and on the insulation layer (33);
a first transparent conductive layer (37) formed on the n-type amorphous silicon layer;
a first collector electrode (38) formed on the first transparent conductive layer;
a second transparent conductive layer (39) formed on the p-type amorphous silicon layer (16); and
a second collector electrode (40) formed on the second transparent conductive layer.

7. A method for producing a solar cell according to claim 1, comprising:
a first step of submerging an n-type crystalline silicon wafer (12, 12z) in an acid aqueous solution containing an n-type dopant, and forming a high concentration n-type dopant-containing silicon oxide layer on an entire surface of the wafer;
a second step of forming an i-type silicon layer (14z) with substantially intrinsic amorphous silicon or a substantially intrinsic polycrystalline silicon layer, as a main component, in a region located on one principal surface of the n-type crystalline silicon wafer (12, 12z), of the high concentration n-type dopant-containing silicon oxide layer;
a third step of thermally treating the n-type crystalline silicon wafer (12, 12z), diffusing the n-type dopant to the n-type crystalline silicon wafer (12, 12z) and the i-type silicon layer (14z) from the high concentration n-type dopant-containing silicon oxide layer, forming, in the entire wafer surface (S1, S2, S3) and in the vicinity of the entire wafer surface (S1, S2, S3), an n⁺ layer (12a) having a higher concentration of the n-type dopant than other regions, and forming an n-type crystalline silicon layer (14) by crystallizing the i-type silicon layer (14z);
a fourth step of removing a part, of a low concentration n-type dopant-containing silicon oxide layer formed by the n-type dopant being partially removed by the third step, that is exposed without being covered with the n-type crystalline silicon layer (14); and
a fifth step of forming a p-type amorphous silicon layer (16)on the other principal surface side of the n-type crystalline silicon wafer (12, 12z).

8. The method for producing a solar cell (10) according to claim 7 further comprising a step of forming a passivation layer (15) on the other principal surface of the n-type crystalline silicon wafer (12, 12z),
Wherein the p-type amorphous silicon layer (16) is formed on the passivation layer (15), and
the passivation layer (15) is made with substantially intrinsic amorphous silicon, or amorphous silicon having a lower concentration of p-type dopant than the p-type amorphous silicon layer (16), as a main component.

9. The method for producing a solar cell (10) according to claim 7 or 8,
wherein in the step of diffusing the n-type dopant, the n-type crystalline silicon wafer (12, 12z) is thermally treated at a temperature of 800°C to 1000°C.

10. The method for producing a solar cell (10) according to any one of claims 7 to 9,
wherein a treatment temperature in the step of forming the n-type dopant-containing silicon oxide layer is 10°C to 90°C.

## Patentansprüche

1. Eine Solarzelle (10), die Folgendes umfasst:
einen kristallinen Siliziumwafer vom n-Typ (12, 12z);
in der gesamten Wafer-Oberfläche (S1, S2, S3) und in der Nähe der gesamten Wafer-Oberfläche (S1, S2, S3), eine n⁺-Schicht (12a) mit einer höheren Konzentration eines n-Typ-Dotierstoffs als andere Bereiche des kristallinen SiliziumWafers vom n-Typ (12, 12z);
eine Siliziumoxidschicht, die auf einer Lichtempfangsfläche (S1) des kristallinen Siliziumwafers vom n-Typ (12, 12z) ausgebildet ist;
eine kristalline Siliziumschicht vom n-Typ (14), die auf der Siliziumoxidschicht ausgebildet ist; und
eine amorphe Siliziumschicht vom p-Typ (16), die auf einer Seite der hinteren Oberfläche des kristallinen Siliziumwafers vom n-Typ (12, 12z) ausgebildet ist,
wobei die Siliziumoxidschicht einen n-Typ-Dotierstoff enthält, und wobei
eine Konzentration des n-Typ-Dotierstoffs in der Siliziumoxidschicht niedriger ist als eine Konzentration von n-Typ-Dotierstoffen in der n⁺-Schicht (12a) und in der kristallinen Siliziumschicht vom n-Typ (14).

2. Die Solarzelle (10) nach Anspruch 1, die ferner eine Passivierungsschicht (15) umfasst, die zwischen dem kristallinen Siliziumwafer vom n-Typ (12, 12z) und der amorphen Siliziumschicht vom p-Typ (16) gebildet ist,
wobei die Passivierungsschicht (15) mit im Wesentlichen intrinsischem amorphem Silizium oder einem amorphen Silizium mit einer geringeren Konzentration eines p-Dotierstoffs als die amorphe Siliziumschicht vom p-Typ (16) als Hauptkomponente hergestellt ist.

3. Die Solarzelle (10) nach Anspruch 1 oder 2,
wobei eine Konzentration des n-Typ-Dotierstoffs in der kristallinen Siliziumschicht vom n-Typ (14) 1x10²¹ Atome/cm³ oder weniger beträgt.

4. Die Solarzelle (10) nach irgendeinem der Ansprüche von 1 bis 3, wobei eine Konzentration des n-Typ-Dotierstoffs in der n⁺-Schicht (12a) 1x10²⁰ Atome/cm³ oder weniger beträgt.

5. Die Solarzelle (10) nach irgendeinem der Ansprüche von 1 bis 4, die Folgendes umfasst:
eine erste transparente leitfähige Schicht (20), die auf der kristallinen Siliziumschicht vom n-Typ (14) ausgebildet ist;
eine erste Kollektorelektrode (21), die auf der ersten transparenten leitfähigen Schicht ausgebildet ist;
eine zweite transparente leitfähige Schicht (22), die auf der amorphen Siliziumschicht vom p-Typ (16) ausgebildet ist; und
eine zweite Kollektorelektrode (23), die auf der zweiten transparenten leitfähigen Schicht ausgebildet ist.

6. Die Solarzelle (30) nach irgendeinem der Ansprüche von 1 bis 4, die Folgendes umfasst:
eine amorphe Siliziumschicht vom n-Typ (32), die auf einem ersten Bereich auf einer hinteren Oberfläche (S2) des kristallinen Siliziumwafers vom n-Typ (31) ausgebildet ist;
eine Isolationsschicht (33), die in einem Teil auf der amorphen Siliziumschicht vom n-Typ ausgebildet ist;
wobei die amorphe Siliziumschicht vom p-Typ (34) auf einem zweiten Bereich der hinteren Oberfläche (S2) des kristallinen Siliziumwafers vom n-Typ (31) und auf der Isolationsschicht (33) ausgebildet ist;
eine erste transparente leitfähige Schicht (37), die auf der amorphen Siliziumschicht vom n-Typ ausgebildet ist;
eine erste Kollektorelektrode (38), die auf der ersten transparenten leitfähigen Schicht ausgebildet ist;
eine zweite transparente leitfähige Schicht (39), die auf der amorphen Siliziumschicht vom p-Typ (16) ausgebildet ist; und
eine zweite Kollektorelektrode (40), die auf der zweiten transparenten leitfähigen Schicht ausgebildet ist.

7. Ein Verfahren zur Herstellung einer Solarzelle nach Anspruch 1, das Folgendes umfasst:
einen ersten Schritt des Eintauchens eines kristallinen Siliziumwafers vom n-Typ (12, 12z) in eine saure wässrige Lösung, die ein Dotiermittel vom n-Typ enthält, und des Bildens einer Siliziumoxidschicht mit hoher Konzentration, die ein n-Typ-Dotiermittel enthält, auf einer gesamten Oberfläche des Wafers;
einen zweiten Schritt des Bildens einer Siliziumschicht vom i-Typ (14z) mit im Wesentlichen intrinsischem amorphem Silizium oder einer im Wesentlichen intrinsischen polykristallinen Siliziumschicht als Hauptkomponente in einem Bereich, der sich auf einer Hauptoberfläche des kristallinen Siliziumwafers vom n-Typ (12, 12z) befindet, der hochkonzentrierten n-Typ-Dotierstoff-haltigen Siliziumoxidschicht;
einen dritten Schritt des thermischen Behandelns des kristallinen Siliziumwafers vom n-Typ (12, 12z), des Diffundierens des n-Typ-Dotierstoffs zu dem kristallinen Siliziumwafer vom n-Typ (12, 12z) und der Siliziumschicht vom i-Typ (14z) ausgehend von der hochkonzentrierten n-Typ-Dotierstoff-haltigen Siliziumoxidschicht, des Bildens in der gesamten Wafer-Oberfläche (S1, S2, S3) und in der Nähe der gesamten Wafer-Oberfläche (S1, S2, S3) einer n⁺-Schicht (12a), die eine höhere Konzentration des n-Typ-Dotierstoffs als andere Bereiche aufweist, und des Bildens einer kristallinen Siliziumschicht vom n-Typ (14) durch Kristallisieren der Siliziumschicht vom i-Typ (14z);
einen vierten Schritt des Entfernens eines Teils einer Siliziumoxidschicht, die einen n-Typ-Dotierstoff mit niedriger Konzentration enthält, was durch das teilweise Entfernen des n-Typ-Dotierstoffs durch den dritten Schritt gebildet wird, und die freiliegt, ohne mit der kristallinen Siliziumschicht vom n-Typ (14) bedeckt zu sein; und
einen fünften Schritt des Bildens einer amorphen Siliziumschicht vom p-Typ (16) auf der anderen Hauptoberflächenseite des kristallinen Siliziumwafers vom n-Typ (12, 12z).

8. Das Verfahren zur Herstellung einer Solarzelle (10) nach Anspruch 7, das ferner einen Schritt umfasst zur Bildung einer Passivierungsschicht (15) auf der anderen Hauptoberfläche des kristallinen Siliziumwafers vom n-Typ (12, 12z),
Wobei die amorphe Siliziumschicht vom p-Typ (16) auf der Passivierungsschicht (15) gebildet wird, und wobei
die Passivierungsschicht (15) mit im Wesentlichen intrinsischem amorphem Silizium oder einem amorphen Silizium mit einer geringeren Konzentration eines p-Dotierstoffs als die amorphe Siliziumschicht vom p-Typ (16) als Hauptkomponente hergestellt ist.

9. Das Verfahren zur Herstellung einer Solarzelle (10) nach Anspruch 7 oder 8,
wobei im Schritt des Diffundierens des n-Typ-Dotierstoffs der kristalline Siliziumwafer vom n-Typ (12, 12z) bei einer Temperatur von 800°C bis 1000°C thermisch behandelt wird.

10. Das Verfahren zur Herstellung einer Solarzelle (10) nach irgendeinem der Ansprüche von 7 bis 9,
wobei eine Behandlungstemperatur im Schritt der Bildung der n-Typ dotierstoffhaltigen Siliziumoxidschicht 10°C bis 90°C beträgt.

## Revendications

1. Une cellule solaire (10) comprenant :
une tranche (*wafer*) de silicium cristallin de type n (12, 12z) ;
dans la totalité de la surface de tranche (S1, S2, S3) et à proximité de la totalité de la surface de tranche (S1, S2, S3), une couche n⁺ (12a) ayant une concentration plus élevée d'un dopant de type n que les autres régions de la tranche de silicium cristallin de type n (12, 12z) ;
une couche d'oxyde de silicium formée sur une surface de réception de lumière (S1) de la tranche de silicium cristallin de type n (12, 12z) ;
une couche de silicium cristallin de type n (14) formée sur la couche d'oxyde de silicium ; et
une couche de silicium amorphe de type p (16) formée sur le côté de la face arrière de la tranche de silicium cristallin de type n (12, 12z),
sachant que la couche d'oxyde de silicium contient un dopant de type n, et que
une concentration du dopant de type n dans la couche d'oxyde de silicium est inférieure à une concentration des dopants de type n dans la couche n⁺ (12a) et dans la couche de silicium cristallin de type n (14).

2. La cellule solaire (10) d'après la revendication 1, comprenant en outre une couche de passivation (15) formée entre la tranche de silicium cristallin de type n (12, 12z) et la couche de silicium amorphe de type p (16),
sachant que la couche de passivation (15) est constituée de silicium amorphe essentiellement intrinsèque, ou d'un silicium amorphe ayant une concentration plus faible d'un dopant de type p que la couche de silicium amorphe de type p (16), comme composant principal.

3. La cellule solaire (10) d'après la revendication 1 ou 2,
sachant que la concentration du dopant de type n dans la couche de silicium cristallin de type n (14) est de 1x10²¹ atomes/cm³ ou moins.

4. La cellule solaire (10) d'après l'une quelconque des revendications de 1 à 3,
sachant que la concentration du dopant de type n dans la couche n⁺ (12a) est de 1x10²⁰ atomes/cm³ ou moins.

5. La cellule solaire (10) d'après l'une quelconque des revendications de 1 à 4 comprenant :
une première couche conductrice transparente (20) formée sur la couche de silicium cristallin de type n (14) ;
une première électrode collectrice (*collector electrode*) (21) formée sur la première couche conductrice transparente ;
une deuxième couche conductrice transparente (22) formée sur la couche de silicium amorphe de type p (16) ; et
une deuxième électrode collectrice (23) formée sur la deuxième couche conductrice transparente.

6. La cellule solaire (30) d'après l'une quelconque des revendications de 1 à 4 comprenant :
une couche de silicium amorphe de type n (32) formée sur une première région sur une surface arrière (S2) de la tranche de silicium cristallin de type n (31) ;
une couche d'isolation (33) formée dans une partie de la couche de silicium amorphe de type n ;
la couche de silicium amorphe de type p (34) formée sur une deuxième région de la surface arrière (S2) de la tranche de silicium cristallin de type n (31), et sur la couche d'isolation (33) ;
une première couche conductrice transparente (37) formée sur la couche de silicium amorphe de type n ;
une première électrode collectrice (38) formée sur la première couche conductrice transparente ;
une deuxième couche conductrice transparente (39) formée sur la couche de silicium amorphe de type p (16) ; et
une deuxième électrode collectrice (40) formée sur la deuxième couche conductrice transparente.

7. Un procédé de fabrication d'une cellule solaire d'après la revendication 1, comprenant :
une première étape consistant à immerger une tranche de silicium cristallin de type n (12, 12z) dans une solution aqueuse acide contenant un dopant de type n, et à former une couche d'oxyde de silicium contenant un dopant de type n à forte concentration sur toute la surface de la tranche ;
une deuxième étape consistant à former une couche de silicium de type i (14z) avec du silicium amorphe essentiellement intrinsèque ou une couche de silicium polycristallin essentiellement intrinsèque, comme composant principal, dans une région située sur une surface principale de la tranche de silicium cristallin de type n (12, 12z), de la couche d'oxyde de silicium contenant un dopant de type n à haute concentration ;
une troisième étape consistant à traiter thermiquement la tranche de silicium cristallin de type n (12, 12z), à diffuser le dopant de type n vers la tranche de silicium cristallin de type n (12, 12z) et la couche de silicium de type i (14z) à partir de la couche d'oxyde de silicium contenant le dopant de type n à haute concentration, à former, dans toute la surface de la tranche (S1, S2, S3) et à proximité de toute la surface de la tranche (S1, S2, S3), une couche n⁺ (12a) ayant une concentration de dopant de type n plus élevée que les autres régions, et à former une couche de silicium cristallin de type n (14) par cristallisation de la couche de silicium de type i (14z) ;
une quatrième étape consistant à enlever une partie, d'une couche d'oxyde de silicium contenant un dopant de type n à faible concentration, formée par l'enlèvement partiel du dopant de type n lors de la troisième étape, qui est exposée sans être recouverte de la couche de silicium cristallin de type n (14) ; et
une cinquième étape consistant à former une couche de silicium amorphe de type p (16) sur l'autre côté de la surface principale de la tranche de silicium cristallin de type n (12, 12z).

8. Le procédé de fabrication d'une cellule solaire (10) d'après la revendication 7, comprenant en outre une étape consistant à former une couche de passivation (15) sur l'autre surface principale de la tranche de silicium cristallin de type n (12, 12z),
Sachant que la couche de silicium amorphe de type p (16) est formée sur la couche de passivation (15), et que
la couche de passivation (15) est constituée de silicium amorphe essentiellement intrinsèque, ou de silicium amorphe ayant une concentration de dopant de type p inférieure à celle de la couche de silicium amorphe de type p (16), comme composant principal.

9. Le procédé de fabrication d'une cellule solaire (10) d'après la revendication 7 ou 8,
sachant que dans l'étape de diffusion du dopant de type n, la tranche de silicium cristallin de type n (12, 12z) est traitée thermiquement à une température de 800°C à 1000°C.

10. Le procédé de fabrication d'une cellule solaire (10) d'après l'une quelconque des revendications de 7 à 9,
sachant qu'une température de traitement dans l'étape de formation de la couche d'oxyde de silicium contenant le dopant de type n est de 10°C à 90°C.
